# EUROPÄISCHE PATENTSCHRIFT

(11) **EP 0 857 345 B1**
(45) Veröffentlichungstag und Bekanntmachung des Hinweises auf die Patenterteilung: **06.11.2002**
(21) Anmeldenummer: 97940090.0
(22) Anmeldetag: 19.08.1997
(51) Int. Cl.: G11C 7/00

(54) **VERFAHREN UND SCHALTUNGSANORDNUNG ZUR SPEICHERUNG VON DIKTATEN BEI EINEM DIGITALEN DIKTIERGERÄT**
PROCESS AND CIRCUIT ARRANGEMENT FOR STORING DICTATIONS IN A DIGITAL DICTATING MACHINE
PROCEDE ET CIRCUITERIE POUR MEMORISER DES DICTEES DANS UN APPAREIL A DICTER NUMERIQUE

(30) Priorität: 21.08.1996 DE 19633648
(43) Veröffentlichungstag der Anmeldung: 12.08.1998
(73) Patentinhaber: GRUNDIG Aktiengesellschaft, 90471 Nürnberg (DE)
(72) Erfinder: CARL, Holger, D-90768 Fürth (DE); KIRCHMANN, Dirk, D-90762 Fürth (DE)
(86) Internationale Anmeldenummer: EP9704511
(87) Internationale Veröffentlichungsnummer: WO98008223

(56) Entgegenhaltungen:
- DE-C- 4 214 053
- GB-A- 2 253 078
- US-A- 5 337 275
- PATENT ABSTRACTS OF JAPAN vol. 018, no. 621 (P-1832), 25.November 1994 & JP 06 236313 A (TEAC CORP), 23.August 1994,

## Beschreibung

Die Erfindung betrifft ein Verfahren zur Speicherung von Diktaten bei einem digitalen Diktiergerät nach dem Oberbegriff des Anspruchs 1, 5 oder 9.

Aus dem Bereich der Personal-Computer, insbesondere dem Betriebssystem DOS, ist bekannt, daß gespeicherte Daten in verschiedene Einheiten zusammengefaßt werden. Die kleinste Informationseinheit ist ein Bit, acht Bit werden zu einem Byte zusammengefaßt, und eine bestimmte Anzahl Bytes (z.B. 512) bildet einen Cluster. Dadurch besteht die Möglichkeit, daß nicht nur bitweise, sondern clusterweise auf Daten zugegriffen werden kann. Dies verkürzt, insbesondere bei Massenspeichem, die für eine Veränderung des Speicherinhalts (z.B. Kopieren oder Löschen) benötigte Zeit.

Weiterhin ist zur Zuordnung einer Datei zu physikalischem Speicherplatz des Massenspeichers ein Inhaltsverzeichnis auf dem Massenspeicher abgespeichert, in dem zu jeder Datei die Adresse des ersten zur Speicherung benutzten Clusters des Massenspeichers abgespeichert ist. Zusätzlich ist ein File-Allocation-Table (kurz FAT genannt) auf dem Massenspeicher gespeichert, der unter der Adresse des momentan benutzten Clusters die Adresse des nächstfolgenden, zur Speicherung der Datei benutzten Clusters enthält. Im letzten zur Speicherung benutzten Cluster weist der File-Allocation-Table FAT einen Datei-Ende Eintrag auf, da kein nächstfolgendes Cluster existiert.

Ein Zugriff auf den Speicherbereich, in dem eine Datei gespeichert ist, erfolgt, indem im Inhaltsverzeichnis des Massenspeichers der Dateiname gesucht wird und die Adresse des ersten Clusters, die in Verbindung mit dem Dateinamen gespeichert ist, für einen Zugriff sowohl auf den File-Allocation-Table FAT als auch auf die Daten der Datei benutzt wird. Durch den Zugriff auf den FAT wird die Adresse des nächstfolgenden Clusters und des nächstfolgenden Eintrags im File-Allocation-Table FAT bekannt. Ist das Dateiende erreicht, besteht dieser Eintrag aus einem Datei-Ende Eintrag. Daran wird erkannt, daß keine weiteren Cluster zu der Datei gehören.

Auch in digitalen Diktiergeräten müssen Dateien abgespeichert werden, die Sprachaufnahmen enthalten und deren Aufbau und Verwaltung wie bei Personal-Computern gemäß den bekannten DOS-Dateiformaten erfolgen soll, um eine Austauschbarkeit der Speichermedien zwischen einem portablem Diktiergerät und einem Personal-Computer zu ermöglichen, jedoch mit den für die Sprachaufzeichnung erforderlichen Modifikationen.

Bei der Sprachaufzeichnung in digitalen Diktiergeräten hat man so lange keine Probleme die meist komprimierten Sprachdaten in eine Datei zu schreiben, wie die Aufnahme höchstens unterbrochen wird, ansonsten aber stets neue Daten an das bisherige Dateiende angehängt werden. Diese Situation ändert sich, wenn sogenannte Editfunktionen ermöglicht werden sollen. Dies ist beispielsweise das Einfügen von Aufnahmen an beliebigen Stellen in die bestehende Aufzeichnung, sowie das Löschen von frei definierbaren Stücken einer bestehenden Aufzeichnung. Diese Funktionen sollen natürlich derart ausgeführt werden, daß eine anschließende Wiedergabe der gesamten Aufnahme die einzelnen Abschnitte in der (logisch) korrekten Reihenfolge und unterbrechungsfrei erfolgt.

Bei Textverarbeitungssystemen kann dies dadurch gelöst werden, daß die Daten der bestehenden Aufzeichnung entsprechend der Einfügung oder Löschung verschoben werden. Textverarbeitungssysteme können so vorgehen, da Textdokumente in der Regel vollständig in den Arbeitsspeicher des Personal-Computers geladen werden, wo Datenbewegungen sehr schnell möglich sind. Da jedoch Sprachdaten im Vergleich zu Textdaten wesentlich mehr Speicher benötigen, ist diese Vorgehensweise selbst bei einem schnellen Speicher, insbesondere aber bei einem langsamen Massenspeicher, sehr zeitraubend und damit benutzerunfreundlich.

Bei einer Speicherung von Sprachdaten in einem Flash-Speicher eines portablen Diktiergeräts ist zudem ein Verschieben von Daten äußerst ineffizient, da ein Flash-Speicher vor dem Beschreiben gelöscht werden muß und das Löschen, das zudem meist nur für große Speicherbereiche gleichzeitig erfolgen kann, einen vergleichsweise hohen Zeit- und Strombedarf erfordert.

Es ist daher die Aufgabe der vorliegenden Erfindung ein Verfahren anzugeben, bei dem die oben genannten Nachteile vermieden werden und ein Editieren von gemäß den DOS-Spezifikationen gespeicherten Dateien möglichst schnell und stromsparend möglich ist, auch wenn die Dateien auf einem relativ langsamen Massenspeicher gespeichert sind. Dies soll insbesondere bei Verwendung von Flash-Speichern als Massenspeicher sichergestellt sein.

Diese Aufgabe wird bei einem Diktiergerät nach dem Oberbegriff von Anspruch 1, 5 oder 9 durch die Merkmale des kennzeichnenden Teils dieser Ansprüche gelöst.
Vorteilhafte Weiterbildungen sind den Unteransprüchen zu entnehmen.

Erfindungsgemäß werden Editfunktionen durch Manipulationen der Verweise auf den nächsten auszugebenden Cluster oder den nächsten auszugebenden Sprachrahmen durchgeführt. Ein Verweis auf einen Cluster mit ausschließlich (logisch) gelöschten Daten wird durch einen Verweis auf den nächstfolgenden Cluster ersetzt, der nicht gelöschte Daten enthält. Dadurch wird die Kette der Cluster aufgebrochen und um die (logisch) gelöschten Daten verkürzt wieder zusammengesetzt. Die freiwerdenden Cluster werden dabei entweder direkt als frei markiert, oder - im Fall von Flash-Speicher - als "dirty" (zum Löschen freigegeben = potentiell frei).

Zusätzlich läßt sich bei Einfügungen leicht die benötigte Zahl von Clustern in die vorhandene, über den File-Allocation-Table verkettete Liste an Clustem aufnehmen, indem an der Stelle, an der die Einfügung erfolgen soll, der Verweis auf den ursprünglich nächsten Cluster durch einen Verweis auf den ersten einzufügenden Cluster ersetzt wird und beim letzten einzufügenden Cluster ein Verweis auf den ursprünglich nächsten Cluster erfolgt.

Bei innerhalb eines Clusters zu löschenden Sprachrahmen wird ein zusätzlicher Verweis auf den ersten Sprachrahmen des Clusters und/oder zusätzlich die Anzahl der im Cluster gespeicherten Sprachrahmen gespeichert, wodurch die Anzahl der auszugebenden Sprachrahmen neu definiert wird. Diese Verweise sind am Beginn eines jeden Clusters an dafür vorgesehenen und reservierten Speicherstellen gespeichert. Bei der Ausgabe muß jeweils geprüft werden, welcher der letzte und damit gültige Eintrag für die Adresse des ersten Sprachrahmens und für die Anzahl der Sprachrahmen ist.

Um ein möglichst effektives Diktieren mit Editierfunktionen (Einfügen, lückenfreies Löschen, Übersprechen vorhandener Diktate in Flash-Speicher) in einem clusterorienterten Betriebssystem auf Minimalhardware (geringer Arbeitsspeicher, begrenzte Prozessorleistung) zu gewährleisten werden insbesondere die im weiteren beschriebenen Maßnahmen ergriffen:
Das clusterorientierte Dateisystems wird durch direkte Manipulation der FAT und/oder eines oder mehrerer Cluster an die Erfordernisse angepaßt.
Es werden Clusterheader mit Einträgen für Startadresse des ersten Sprachrahmens und der Sprachrahmenanzahl je Cluster, mit jeweils mehreren Einträgen für Korrekturmöglichkeiten, welche besonders in Flashspeichersystemen sinnvoll sind und einen Eintrag für den verwendeten Sprachkodieralgorithmus aufweisen, benutzt.
Diese Art des Clusterheaders ermöglicht eine optimale Speicherausnutzung durch clusterübergreifende Anordnung der Sprachrahmen.
Außerdem wird eine, gemessen am Speicherverbrauch des Headers, große Speicherauflösung erzielt. Dies ist insbesondere wichtig für sogenannte Silencerahmen bei Sprachkodieralgorithmen mit Sprachpausenkomprimierung, die relativ wenig Speicherplatz benötigen. Durch die Einfügung von Rahmenheader vor jeden Sprachrahmen, wird die Kodierung unterschiedlicher Rahmenlängen, z.B. für speicherplatzsparende Sprachkodieralgorithmen mit Sprachpausenerkennung, ermöglicht.

Die Merkmale der Ansprüche werden im folgenden an exemplarischen Ausführungsbeispielen anhand der Zeichnung erläutert. Die Ausführungsbeispiele sind keine erschöpfende Aufzählung der erfindungsgemäßen Ausgestaltungsmöglichkeiten, sondern haben nur beispielhaften Charakter.

Es zeigt:
- Fig. 1:: die physikalische und logische Anordnung der Sprachrahmen in einem Cluster,
- Fig. 2:: die Belegung eines Massenspeichers mit einer Datei, bei der in einem File-Allocation-Table Verweise auf die nächstfolgenden Cluster vorgesehen sind,
- Fig. 3:: die physikalische und logische Anordnung der Cluster einer Datei im Massenspeicher nach einer Einfügung.
- Fig. 4:: eine beispielhafte Darstellung eines Diktatclusters.

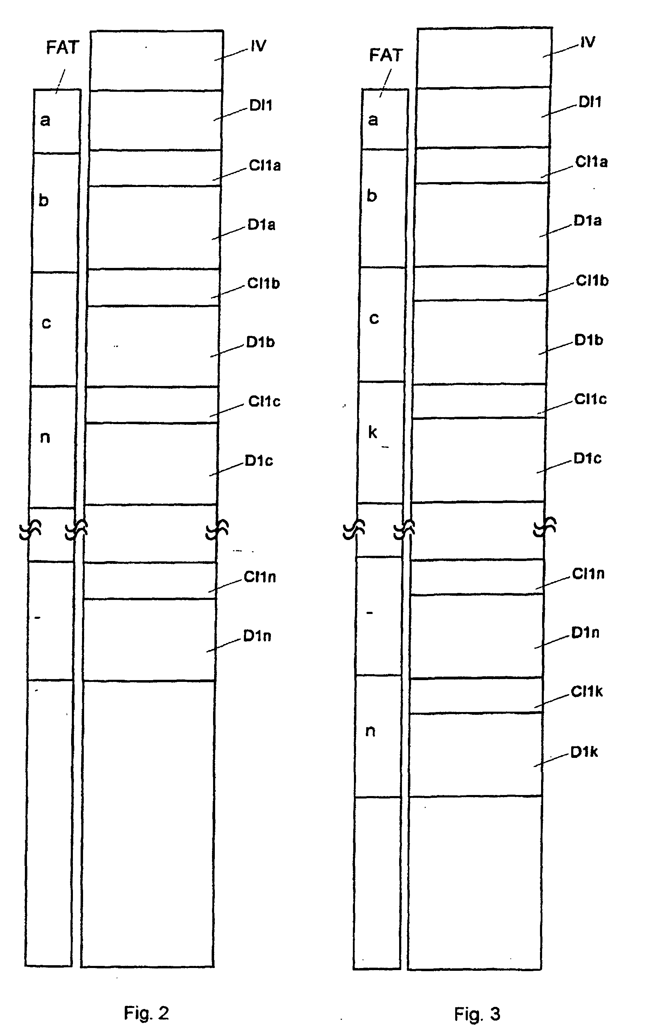

Fig. 2 zeigt schematisch eine mögliche Belegung eines Massenspeichers, insbesondere eines Plattenspeichers oder eines ebenso verwalteten Halbleiterspeichers,
- mit einem File-Allocation-Table FAT, der für jeden Cluster eine Kennung für dessen Belegungszustand enthält, sowie einem Inhaltsverzeichnis IV zur Zuordnung von Dateinamen zu dem ersten Cluster jeder gespeicherten Datei,
- mit Dateien, die mit einer Dateiinformation Dlx beginnen und deren Daten Dx in Clustem gespeichert sind, wobei jeder Cluster neben den Daten Dx eine Clusterinformation CIx enthält.

Im Massenspeicher ist zunächst ein Inhaltsverzeichnis IV gespeichert, durch das in einem ersten Haupteintrag einer Dateikennung, insbesondere einem Dateinamen, ein erster Cluster des Massenspeichers zugeordnet wird, wie es aus DOS bekannt ist.

Weiterhin sind in der FAT Informationen über den Belegungszustand jedes Clusters des Massenspeichers gespeichert, um schnell die belegten und freie Cluster des Massenspeichers erkennen zu können, ebenfalls bereits aus DOS bekannt.

Zu Beginn eines ersten Diktats wird eine Dateiinformation DI1, im weiteren als Diktatheader bezeichnet, abgespeichert, die verschiedene Informationen enthält, die bei der Wiedergabe des Diktats von Bedeutung sind. Insbesondere sind Informationen im Diktatheader, wie z.B. Anzahl der Dateiheadercluster, Dateitypenerkennung, Versionsnummer, Softwarelizenznummer, Autor, Bearbeitungsnumer, Bearbeitungszustand, Aufzeichnungszeitpunkt, Aufzeichnungsende, Diktatlänge, Schreibschutz und Zusatzinformationen enthalten. Zusatzinformatinen beinhalten Speicheradressen von separaten Spracheinfügungen, sogenannten Sprachinfos, welche gesondert vom Benutzer des Diktiergerätes für Ab- und/oder Anlegen von Zusatzinformationen verwendet werden können. Weiterhin können Informationen, die für die Wiedergabe von Bedeutung sind, ebenfalls in der Dateiinformation DI1 gespeichert werden.

Anschließend folgt die Clusterinformation CI1a des ersten Clusters. Diese beinhaltet die Speicheradresse des ersten Sprachrahmens des Clusters, die Anzahl der im Cluster gespeicherten Sprachrahmen sowie eine Kennung für den verwendeten Kompressionsalgorithmus. In der Clusterinformation CI1a können diese Informationen mehrmals abgespeichert werden, um Änderungen ohne Löschvorgänge möglich zu machen. Hierdurch wird eine lückenlose, clusterübergreifende Aneinanderreihung von Sprachrahmen verschiedenster Länge, sowie eine speicherplatzsparende und effiziente Unterteilung der einzelnen Clusterer in Sprachrahmen ermöglicht. Das Verhältnis der Anzahl der Unterteilungen des Clusters in Sprachrahmen, zum Speicherbedarf der Clusterinformation, ist sehr hoch. Im Gegensatz zum Stand der Technik, bei welchem zu jedem Sprachrahmen ein Gültigkeitsflag gesetzt wird, wird bei der Erfindung die Startadresse des ersten Sprachrahmens, sowie die Anzahl der Sprachrahmen abgespeichert. Hierdurch wird für eine vorgegebene Anzahl von Sprachrahmen insgesamt nur ein Adressbereich verwendet, unabhängig von der maximalen Anzahl der möglichen, in einem Cluster speicherbaren, Sprachrahmen. Anderfalls müßte für jeden einzelnen Sprachrahmen, der maximal möglichen Rahmen, jeweils ein Gültigkeitsflag gesetzt werden. Dies würde zu einem höheren Speicherbedarf führen.

Aufgrund der Segmentierung des Sprachsignals während der Kompression werden jeweils Sprachrahmen mit ca. 20 ms Dauer des Sprachsignals kodiert. Dadurch ist eine zeitliche Genauigkeit möglich, die der Dauer eines Sprachrahmens entspricht. Der Speicherbedarf der Sprachrahmen kann unterschiedlich sein. In der Regel wird nicht jeder Cluster mit einem neuen Sprachrahmen beginnen. Es ist somit erforderlich, in jedem Cluster den Beginn des ersten Sprachrahmens in Form der Speicheradresse des ersten Sprachrahmens anzugeben.

Durch die Angabe der Anzahl von im Cluster gespeicherten Sprachrahmen und der Speicheradresse des ersten Sprachrahmens wird es möglich, am Beginn und am Ende eines Clusters Sprachrahmen logisch zu löschen, wodurch diese nicht mehr ausgegeben werden, ohne daß der Speicher physikalisch gelöscht werden muß. Sollen beispielsweise am Beginn des Clusters drei Sprachrahmen logisch gelöscht werden, wird als Speicheradresse des ersten Sprachrahmens die Adresse des vierten im Cluster physikalisch vorhandenen Sprachrahmens angegeben und die Anzahl der im Cluster vorhandenen Sprachrahmen von acht auf fünf gesetzt. Dadurch werden die ersten drei gespeicherten Sprachrahmen bei der Wiedergabe übersprungen.

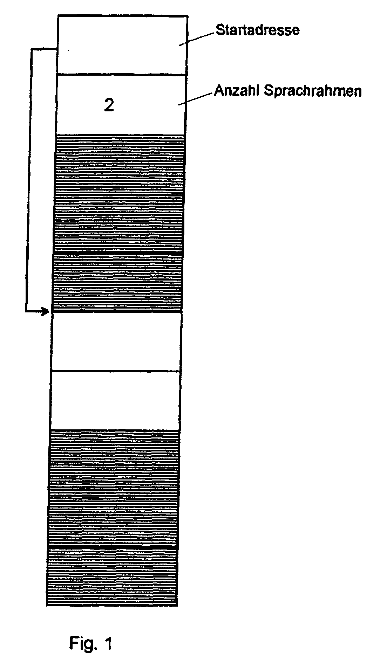

Sollen die letzten drei Sprachrahmen logisch gelöscht werden, wird nur die Anzahl der im Cluster gespeicherten Sprachrahmen von fünf auf zwei gesetzt, wie in Fig. 1 dargestellt. Dadurch werden die letzten drei Sprachrahmen übersprungen. Die nicht mehr benötigten Sprachrahmen müssen nicht mehr unmittelbar physikalisch gelöscht werden. Es reicht aus, wenn diese als nicht belegt gekennzeichnet werden. Insbesondere bei der Verwendung von Flash-Speichern ist dies vorteilhaft, da diese Speicher in der Regel nur clusterweise, bzw. in Vielfachen von Clustem, gelöscht werden können. Ein Löschen eines einzelnen Sprachrahmens in einem Cluster ist nicht möglich.

Sobald ein ganzer Cluster keine Sprachrahmen mehr enthält, die wiedergegeben werden sollen, wird der Eintrag im File-Allocation-Table FAT des Massenspeichers manipuliert, so daß der ganze Cluster nicht mehr wiedergegeben wird. Ein Verweis auf einen Cluster mit ausschließlich logisch gelöschten Daten wird durch einen Verweis auf den nächstfolgenden Cluster derselben Datei ersetzt, der nicht gelöschte Daten enthält. Dadurch wird die Kette der Cluster aufgebrochen und um die (logisch) gelöschten Daten verkürzt wieder zusammengesetzt. Die freiwerdenden Cluster werden dabei entweder direkt als frei, oder - im Fall von Flash-Speicher - als "dirty" (zum Löschen freigegeben = potentiell frei) markiert. Enthält der Eintrag im File-Allocation-Table FAT für den ersten Cluster einer Datei vor dem Löschvorgang einen Verweis auf einen zweiten Cluster und der Eintrag im File-Allocation-Table FAT für diesen Cluster einen Verweis auf einen dritten Cluster, so wird durch einen Löschvorgang, bei dem die Sprachrahmen des zweiten Clusters vollständig gelöscht werden, der Verweis im File-Allocation-Table FAT für den ersten Cluster derart geändert, daß dieser nicht mehr auf den zweiten sondern auf den dritten Cluster verweist. Der zweite Cluster wird zumindest durch eine entsprechende Markierung zum Löschen freigegeben. Dadurch wird erreicht, daß bei einer Wiedergabe nur noch die Sprachrahmen des ersten und dritten Clusters ausgegeben werden.

Umgekehrt läßt sich bei Einfügungen leicht die benötigte Zahl von Clustern in die vorhandene Reihenfolge der Cluster aufnehmen, indem an der Stelle, an der die Einfügung erfolgen soll, der Eintrag im File-Allocation-Table FAT auf den ursprünglich nächsten Cluster durch einen Verweis auf den ersten einzufügenden Cluster ersetzt wird und beim letzten einzufügenden Cluster im File-Allocation-Table FAT ein Verweis auf den ursprünglich nächsten Cluster erfolgt. Die einzufügenden Cluster können dabei an einer beliebigen Stelle des Massenspeichers physikalisch angeordnet sein.

Das erfindungsgemäße Verfahren ermöglicht es daher, Veränderungen besonders schnell durchzuführen. Dafür werden durch Verändern der Verweise auf den jeweils nächstfolgenden Cluster sowohl Cluster in eine Datei eingefügt als auch Cluster aus einer Datei entfernt.

Zusätzlich ist in der Clusterinformation CIx gespeichert, wieviele Sprachrahmen in dem betreffenden Cluster gespeichert sind und ab welcher Adresse der erste Sprachrahmen gespeichert ist. Dadurch ist es möglich am Anfang oder Ende eines Clusters einzelne Sprachrahmen, die die kleinste Unterteilung des gespeicherten Sprachsignals bilden, aus der Datei zu entfernen. Derart können Teile einer Datei logisch gelöscht werden, ohne einen Löschvorgang physikalisch durchführen zu müssen. Dadurch wird sowohl Strom für einen Löschvorgang als auch Bearbeitungszeit eingespart.

Der Sprachrahmenheader beinhaltet beispielsweise Informationen über die Sprachpausenunterdrückung, welche in verschiedenen Stufen erfolgen kann, abhängig von der Qualität der Aufzeichnung.

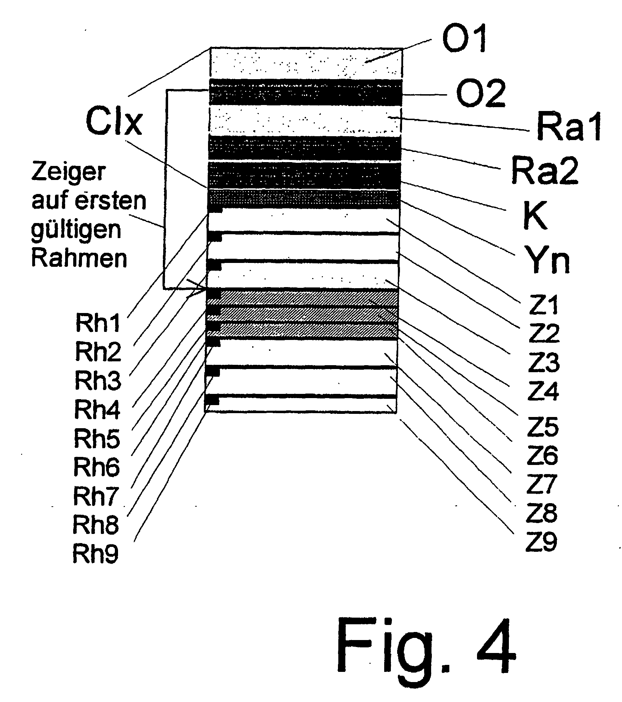

Eine beispielhafte Darstellung eines Diktatclusters wird im folgenden anhand der Fig. 4 beschrieben.

Die Darstellung zeigt einen Dateicluster, wie er insbesondere bei Flashspeichern vorkommt. Im Cluster sind Sprachrahmen als ungültig markiert.
Der Dateicluster besteht aus der Clusterinformation CIx, die wiederum aus den Einträgen O1, O2, Ra1, Ra2 und K besteht. Mit O1 und O2 sind Einträge für die Adresse des ersten Sprachrahmens bezeichnet. Ra1 und Ra2 definieren die Anzahl der Sprachrahmen. Ra1 ist O1 zugeordnet, Ra2 ist O2 zugeordnet. Der Eintrag O1 ist im Beispiel ungültig, O2 hingegen gültig und zeigt auf den ersten gültigen Sprachrahmen Z4. Die Sprachrahmen Z1 bis Z3 sind somit als ungültig markiert. Der Sprachrahmen Yn ist im vorherigen Cluster als letzter Sprachrahmen gespeichert, überschreitet den vorherigen Cluster und wird im aktuellen Cluster abgeschlossen. Hierdurch entsteht eine lückenlose Ausnutzung des Speichers. In Ra2 ist die Anzahl der gültigen Sprachrahmen im Cluster, welche mit dem Sprachrahmen Z4 beginnt, dessen Adresse in O2 abgelegt ist. In Ra2 steht der Wert 4, wonach die Sprachrahmen Z4 bis Z7 gültig sind. Mit K ist der Kompressionsalgorithmus bezeichnet.
Mit Rh1 bis Rh9 sind die Sprachrahmenheader bezeichnet. In den Sprachrahmenheadem Rh1 bis Rh3, sowie Rh7 bis Rh9 ist vermerkt, daß es sich bei diesen Sprachrahmen (Z1 bis Z3 und Z7 bis Z9) um Sprachrahmen mit Sprache handelt. Rh4 bis Rh6 kennzeichnet die Sprachrahmen Z4 bis Z6 in welchen Sprachpauseninformation gespeichert sind.

Beim Auslesen der Information wird zunächst die Information O1 ausgelesen und als ungültig erkannt. Daher wird im nächsten Schritt die Information aus O2 ausgelesen. Da diese Information als gültig erkannt wird, wird Ra2 ausgelesen, worin die Anzahl der gültigen Sprachrahmen definiert ist. Anschließend wird K ausgelesen und ausgewertet und somit der Kompressionsalgorithmus erkannt. Im nächsten Schritt wird auf die Adresse des ersten gültigen Sprachrahmens (O2) zugegriffen. Der Rahmenheader Rh4 von Z4 wird ausgewertet und hieraus ergibt ich, ob es sich um einen Rahmen mit Sprachinformation oder um einen Rahmen mit Sprachpausen handelt. Sprachpausen haben den Vorteil, daß die Rahmen bei zeitlich gleicher Länge, weniger Speicherplatz benötigen. Anschließend werden die gültigen Sprachrahmen ausgelesen, decodiert und wiedergegeben. Nach dem Auslesen des letzten gültigen Sprachrahmens Z7, wird der nächste Cluster ermittelt und, wie oben beschrieben, verarbeitet.

Zur Durchführung dieses Verfahrens ist eine geeignete Steuereinheit in Form eines Mikroprozessors erforderlich, die bei der Wiedergabe einer Datei, die bei einem Diktiergerät in aller Regel ein Diktat enthält, aus dem Inhaltsverzeichnis IV die Adresse des ersten Clusters und des Eintrags im File-Allocation-Table FAT des gewünschten Diktats ausliest. Nach der derartigen Ermittlung der Adresse wird die Clusterinformation CI1a des ersten Clusters aus dem Massenspeicher ausgelesen und aufgrund dieser Information bestimmt, welche Sprachrahmen aus dem Massenspeicher ausgelesen und akustisch ausgegeben werden. Sobald alle als relevant gekennzeichneten Sprachrahmen dieses Clusters, die als Daten D1a gespeichert sind, ausgegeben wurden, wird mit der im File-Allocation-Table FAT enthaltenen Adresse des nächstfolgenden Clusters die Clusterinformation CI1b des nächstfolgenden Clusters und der nächste Eintrag aus dem File-Allocation-Table FAT ausgelesen und anschließend die als relevant gekennzeichneten Sprachrahmen dieses Clusters aus den Daten D1b ausgelesen und akustisch ausgegeben. Dieser Vorgang wiederholt sich, bis im File-Allocation-Table FAT keine Adresse eines weiteren Clusters, sonder eine Datei-Ende-Marke enthalten ist. Daran erkennt die Steuereinheit, daß kein weiterer Cluster ausgegeben werden soll und beendet die Wiedergabe.

Bei der Aufzeichnung eines Diktats werden Sprachdaten auf dem Massenspeicher gespeichert. Dabei sucht die Steuereinheit zunächst im Inhaltsverzeichnis IV als frei markierte Cluster, die für die Speicherung benutzt werden können. Nach der Speicherung der Sprachdaten in Form von Sprachrahmen, die von einem Codierer ausgegeben werden, erzeugt die Steuereinheit automatisch die jeweilige Clusterinformation CIx, die am Anfang des Clusters abgespeichert wird. In der Regel werden mehrere Sprachrahmen nicht exakt einen Cluster ausfüllen, so daß Teile von Sprachrahmen auch in einem folgenden Cluster gespeichert werden. Daher ermittelt die Steuereinheit die Startadresse des ersten im Cluster beginnenden Sprachrahmens und die Anzahl der im Cluster beginnenden Sprachrahmen und steuert die Speicherung dieser Angaben am Anfang des Clusters in die dafür vorgesehenen Speicherplätze.

Spätestens wenn der nächste freie Cluster zur weiteren Speicherung ermittelt wurde, wird dessen Startadresse in einem Eintrag im File-Allocation-Table FAT gespeichert, der mit dem vorhergehenden Cluster ausgelesen wird. Am Ende des Diktats wird anstelle der Startadresse des folgenden Clusters automatisch eine Datei-Ende Marke von der Steuereinheit im File-Allocation-Table FAT gespeichert.

Soll nach dem Diktat eine Einfügung gemacht werden, so gibt der Benutzer die Stelle an, an der die Einfügung erfolgen soll. Die Steuereinheit erkennt den Cluster und den Sprachrahmen, nach dem die Einfügung erfolgen soll, sie sucht im Inhaltsverzeichnis IV den nächsten freien Cluster, weiterhin speichert sie die Adresse des ursprünglich nächsten Clusters und die noch folgenden Sprachrahmen des aktuellen Clusters in einem Zwischenspeicher. Außerdem verändert die Steuereinheit die Clusterinformation CIx dieses Clusters derart, daß die Sprachrahmen, die nach der Stelle, an der die Einfügung erfolgen soll, nicht mehr relevant sind und ersetzt den Verweis im File-Allocation-Table FAT auf den ursprünglich nächsten Cluster durch einen Verweis auf den nächsten als frei ermittelten Cluster. Dann erfolgt die Speicherung der einzufügenden Sprachrahmen. Hat der Benutzer die Einfügung beendet, fügt die Steuereinheit die zwischengespeicherten Sprachrahmen aus dem Zwischenspeicher an und speichert in dem Eintrag im File-Allocation-Table FAT, der mit dem aktuellen Cluster ausgelesen wird, den Verweis aus dem Zwischenspeicher auf den ursprünglich folgenden Cluster.

Durch eine Veränderung der im File-Allocation-Table FAT gespeicherten Verweise werden bei einer Einfügung die einzufügenden Cluster in die logische Reihenfolge der ursprünglich belegten Cluster eingefügt und dadurch die Wiedergabereihenfolge verändert.

Für den Fall, daß die in der Clusterinformation CIx gespeicherte Information über die Anzahl im Cluster relevanter Sprachrahmen, die Startadresse des ersten Sprachrahmens und die Startadresse des nächstfolgenden Clusters nicht überschrieben werden sollen oder können, besteht die Möglichkeit, daß jeweils mehrere Speicherbereiche in der Clusterinformation CIx für diese Information vorgesehen werden und bei einer Veränderung die neue Information im nächsten, noch freien Speicherbereich gespeichert wird. Die Steuereinheit wertet dann immer die Information im letzten beschriebenen Speicherbereich aus. Welcher dies ist, erkennt die Steuereinheit an dem gespeicherten Wert.

## Patentansprüche

1. Verfahren zur Speicherung von Sprachdaten in Dateien bei einem digitalen Diktiergerät, bei dem der Speicher für die Sprachdaten in Cluster unterteilt wird und jedem Cluster ein Verweis in einem File-Allocation-Table (FAT) auf den nächstfolgenden Cluster der Datei zugeordnet wird und dem letzten Cluster einer Datei ein Datei-Ende-Signal (-) zugeordnet wird,
**dadurch gekennzeichnet,**
**daß** die Cluster in Sprachrahmen unterteilt werden,
**daß** in jedem Cluster eine Gültigkeitsinformation (CIx) für die darin gespeicherten Sprachrahmen (Dx) gespeichert wird,
**daß** die Gültigkeitsinformation (CIx) angibt, ab welcher Speicherstelle der erste Sprachrahmen (Startadresse) des Clusters beginnt und wieviele Sprachrahmen (Anzahl Sprachrahmen) in dem Cluster gespeichert sind, daß in dem übrigen Speicherbereich eines Clusters die Daten der codierten Sprachrahmen gespeichert werden,
**daß** die Sprachrahmen mit Sprachrahmenheadem gekennzeichnet werden.

2. Verfahren nach Anspruch 1,
**dadurch gekennzeichnet,**
**daß** für eine mindestens zweimalige Speicherung der Gültigkeitsinformation (CIx), bestehend aus Startadresse des ersten Sprachrahmens (Startadresse) und Anzahl der im Cluster gespeicherter Sprachrahmen (Anzahl Sprachrahmen), Speicherstellen vorgesehen sind.

3. Verfahren nach Anspruch 1 oder 2,
**dadurch gekennzeichnet,**
**daß** in den Sprachrahmenheadem Kennzeichen enthalten sind, welche anzeigen, ob in den Rahmen Sprachinformation oder Sprachpauseninformation enthalten ist.

4. Verfahren nach Anspruch 1 oder 3,
**dadurch gekennzeichnet,**
**daß** in den Sprachrahmenheadern Merkmale zur Qualttätsabstufung der Sprachsignale enthalten sind.

5. Verfahren zur Veränderung von in Dateien gespeicherten Sprachdaten bei einem digitalen Diktiergerät, bei dem der Speicher für die Sprachdaten in Cluster unterteilt wird und jedem Cluster ein Verweis in einem File-Allocation-Table (FAT) auf den nächstfolgenden Cluster der Datei zugeordnet wird und dem letzten Cluster einer Datei ein Datei-Ende-Signal (-) zugeordnet wird,
**dadurch gekennzeichnet,**
**daß** die Cluster in Sprachrahmen unterteilt werden,
**daß** in jedem Cluster eine Gültigkeitsinformation (CIx) für die darin gespeicherten Sprachrahmen (Dx) gespeichert wird,
**daß** die Gültigkeitsinformation (CIx) angibt, ab welcher Speicherstelle der erste Sprachrahmen (Startadresse) des Clusters beginnt und wieviele Sprachrahmen (Anzahl Sprachrahmen) in dem Cluster gespeichert sind,
**daß** zum Einfügen oder Entfernen von einem oder mehreren Clustern in eine Datei die im File-Allocation-Table (FAT) gespeicherten Verweise (a, b, c, k, n) auf einzufügende oder zu löschende Cluster derart geändert werden, daß die gewünschte Reihenfolge der Cluster hergestellt wird.

6. Verfahren nach Anspruch 5,
**dadurch gekennzeichnet,**
**daß** beim Einfügen mindestens eines Clusters in eine Datei der dem letzten Cluster vor der Einfügung zugeordnete Verweis (n) derart verändert wird, daß er auf das erste einzufügende Cluster weist und daß der dem letzten einzufügenden Cluster zugeordnete Verweis derart geändert wird, daß er auf den ersten Cluster nach der Einfügung verweist.

7. Verfahren nach Anspruch 5 oder 6,
**dadurch gekennzeichnet,**
**daß** beim Entfernen mindestens eines Clusters aus einer Datei der dem letzten Cluster vor den zu entfernenden Clustern zugeordnete Verweis derart geändert wird, daß er auf den ersten Cluster nach den zu entfernenden Clustem verweist.

8. Verfahren nach Anspruch 7,
**dadurch gekennzeichnet,**
**daß** innerhalb eines Clusters ein oder mehrere Sprachrahmen am Beginn und/oder am Ende des Clusters von der Wiedergabe ausgeblendet werden, indem die Gültigkeitsinformation (CIx) des Clusters derart verändert wird, daß die Speicherstelle des ersten Sprachrahmens (Startadresse) und/oder die Anzahl gespeicherter Sprachrahmen (Anzahl Sprachrahmen) an einem dafür vorgesehenen Speicherplatz erneut gespeichert wird.

9. Verfahren zur Ausgabe von in Dateien gespeicherten Sprachdaten bei einem digitalen Diktiergerät, bei dem der Speicher für die Sprachdaten in Cluster unterteilt wird und jedem Cluster ein Verweis in einem File-Allocation-Table (FAT) auf den nächstfolgenden Cluster der Datei zugeordnet wird und dem letzten Cluster einer Datei ein Datei-Ende-Signal (-) zugeordnet wird und
daß die in einer Datei gespeicherten Sprachdaten in der im File-Allocation-Table (FAT) angegebenen Reihenfolge aus dem Speicher ausgelesen werden,
**dadurch gekennzeichnet,**
**daß** eine in jedem Cluster gespeicherte Gültigkeitsinformation (CIx) durch eine Steuereinheit ausgewertet wird und die derart als gültig
gekennzeichneten in dem Cluster gespeicherten Sprachrahmen von der Steuereinheit aus dem Speicher ausgelesen, decodiert und ausgegeben werden.

10. Verfahren nach Anspruch 9,
**dadurch gekennzeichnet,**
**daß** die Steuereinheit die gespeicherte Gültigkeitsinformation (CIx), bestehend aus Startadresse des ersten Sprachrahmens (Startadresse) und die Anzahl gespeicherter Sprachrahmen (Anzahl Sprachrahmen), so oft auswertet, bis die Steuereinheit erkennt, daß für die Startadresse des ersten Sprachrahmens und/oder die Anzahl gespeicherter Sprachrahmen ein unmöglicher Wert vorliegt und daß dann die unmittelbar davor ermittelten Werte benutzt werden, wodurch immer die zuletzt gespeicherte Gültigkeitsinformation (CIx) benutzt wird.

11. Verfahren nach Anspruch 9 oder 10,
**dadurch gekennzeichnet,**
**daß** in den Sprachrahmenheadern Kennzeichen enthalten sind, welche anzeigen, ob in den Rahmen Sprachinformation oder Sprachpauseninformation enthalten ist.

12. Verfahren nach einem der Ansprüche 9 bis 11,
**dadurch gekennzeichnet,**
**daß** in den Sprachrahmenheadern Merkmale zur Qualttätsabstufung der Sprachsignale enthalten sind.

## Claims

1. Method for storing speech data in files in the case of a digital dictation machine, in which the memory for the speech data is subdivided into clusters, and a reference in a file allocation table (FAT) to the next cluster of the file is allocated to each cluster, and an end-of-file signal (-) is allocated to the last cluster of a file,
**characterised**
**in that** the clusters are subdivided into speech frames,
**in that** validity information (CIx) is stored in each cluster for the speech frames (Dx) stored in it,
**in that** the validity information (CIx) indicates from which memory location the first speech frame (start address) of the cluster begins and how many speech frames (number of speech frames) are stored in the cluster,
**in that** the data of the encoded speech frames are stored in the remaining memory range of a cluster,
**in that** the speech frames are labelled with speech-frame headers.

2. Method according to Claim 1,
**characterised**
**in that** memory locations are provided for storing, at least twice, the validity information (CIx) consisting of the start address of the first speech frame (start address) and the number of speech frames (number of speech frames) stored in the cluster.

3. Method according to Claim 1 or 2,
**characterised**
**in that** the speech-frame headers contain labels which indicate whether speech information or speech-pause information is contained in the frames.

4. Method according to Claim 1 or 3,
**characterised**
**in that** the speech-frame headers contain features for quality grading of the speech signals.

5. Method for modifying speech data stored in files in the case of a digital dictation machine, in which the memory for the speech data is subdivided into clusters, and a reference in a file allocation table (FAT) to the next cluster of the file is allocated to each cluster, and an end-of-file signal (-) is allocated to the last cluster of a file,
**characterised**
**in that** the clusters are subdivided into speech frames,
**in that** validity information (CIx) is stored in each cluster for the speech frames (Dx) stored in it,
**in that** the validity information (CIx) indicates from which memory location the first speech frame (start address) of the cluster begins and how many speech frames (number of speech frames) are stored in the cluster,
**in that**, for insertion or removal of one or more clusters in a file, the references (a, b, c, k, n) stored in the file allocation table (FAT) to clusters to be inserted or deleted are changed in such a way that the desired sequence of the clusters is produced.

6. Method according to Claim 5,
**characterised**
**in that**, during the insertion of at least one cluster into a file, the reference (n) allocated to the last cluster before the insertion is modified in such a way that it points to the first cluster to be inserted, and in that the reference allocated to the last cluster to be inserted is changed in such a way that it refers to the first cluster after the insertion.

7. Method according to Claim 5 or 6,
**characterised**
**in that**, during the removal of at least one cluster from a file, the reference allocated to the last cluster before the clusters to be removed is changed in such a way that it refers to the first cluster after the clusters to be removed.

8. Method according to Claim 7,
**characterised**
**in that**, within a cluster, one or more speech frames at the beginning and/or end of the cluster are masked from the playback by modifying the validity information (CIx) of the cluster in such a way that the memory location of the first speech frame (start address) and/or the number of stored speech frames (number of speech frames) is stored afresh at a memory position intended for this.

9. Method for outputting speech data stored in files in the case of a digital dictation machine, in which the memory for the speech data is subdivided into clusters, and a reference in a file allocation table (FAT) to the next cluster of the file is allocated to each cluster, and an end-of-file signal (-) is allocated to the last cluster of a file, and
the speech data stored in a file are read from the memory in the sequence indicated in the file allocation table (FAT)
**characterised**
**in that** validity information (CIx) stored in each cluster is evaluated by a control unit, and the speech frames stored in the cluster, which are thereby labelled as valid, are read from the memory, decoded and output by the control unit.

10. Method according to Claim 9,
**characterised**
**in that** the control unit repeatedly evaluates the stored validity information (CIx), consisting of the start address of the first speech frame (start address) and the number of stored speech frames (number of speech frames), until the control unit recognises that there is an impossible value for the start address of the first speech frame and/or the number of stored speech frames, and in that the values determined immediately before this are then used, so that the validity information (CIx) stored last is always used.

11. Method according to Claim 9 or 10,
**characterised**
**in that** the speech-frame headers contain labels which indicate whether speech information or speech-pause information is contained in the frames.

12. Method according to one of Claims 9 to 11,
**characterised**
**in that** the speech-frame headers contain features for quality grading of the speech signals.

## Revendications

1. Procédé pour mémoriser des données vocales dans des fichiers dans une machine à dicter numérique, dans lequel la mémoire pour les données vocales est subdivisée en groupes et à chaque groupe est associée une référence dans une table d'affectation de fichiers (FAT) dans le groupe immédiatement suivant du fichier et au dernier groupe d'un fichier est associé un signal de fin de fichier (-), **caractérisé en ce que**
les groupes sont divisés en trames vocales;
que dans chaque groupe est mémorisée une information de validité (Clx) pour les trames vocales (Dx), qui y sont mémorisées;
que l'information de validité (Clx) indique à partir de quel emplacement de mémoire commence la première trame vocale (adresse de départ) du groupe et combien de trames vocales (nombre de trames vocales) sont mémorisées dans le groupe,
que les données des trames vocales codées sont mémorisées dans la zone de mémoire restante d'un groupe, et
que ces trames vocales sont **caractérisées par** des en-têtes de trames vocales.

2. Procédé selon la revendication 1, **caractérisé en ce que** des emplacements de mémoire sont prévus pour une mémorisation exécutée au moins deux fois, de l'information de validité (Clx), constituée par une adresse de départ de la première trame vocale (adresse de départ) et un nombre des trames vocales (nombre de trames vocales) mémorisées dans le groupe.

3. Procédé selon la revendication 1 ou 2,
**caractérisé en ce que** les en-têtes de trames vocales contiennent des identificateurs qui indiquent si une information vocale ou une information de pause de conversation est contenue dans la trame.

4. Procédé selon la revendication 1 ou 3,
**caractérisé en ce qu'**à des caractéristiques d'étagement de qualité des signaux vocaux sont contenus dans les en-têtes des trames vocales.

5. Procédé pour modifier des données vocales mémorisées dans des fichiers, dans une machine à dicter numérique, selon lequel la mémoire pour les données vocales est subdivisée en groupes et à chaque groupe est associé une référence dans une table d'affectation de fichiers (FAT) sur le groupe immédiatement suivant des fichiers, et au dernier groupe d'un fichier est associé un signal de fin de fichier (-),
caractérisé en ce
les groupes sont divisés en trames vocales;
que dans chaque groupe est mémorisée une information de validité (Clx) pour les trames vocales (Dx), qui y sont mémorisées;
que l'information de validité (Clx) indique à partir de quel emplacement de mémoire commence la première trame vocale (adresse de départ) du groupe et combien de trames vocales (nombre de trames vocales) sont mémorisées dans le groupe,
que pour l'insertion ou le retrait d'un ou de plusieurs groupes dans un fichier, les références (a, b, c, k, n), mémorisées dans la table d'affectation de fichiers (FAT) à des groupes devant être introduits ou effacés sont modifiées de telle sorte que la succession désirée des groupes est établie.

6. Procédé selon la revendication 5, **caractérisé en ce que** lors de l'insertion d'au moins un groupe dans un fichier, la référence (n), associée au dernier groupe avant l'introduction, est modifiée de manière qu'elle indique le premier groupe devant être introduit et que la référence associée au dernier groupe devant être introduit est modifiée de manière à désigner le premier groupe après l'insertion.

7. Procédé selon la revendication 5 ou 6,
**caractérisé en ce que** lors du retrait d'au moins un groupe à partir d'un fichier, la référence associée au dernier groupe avant les groupes à retirer est modifiée de manière que cette référence désigne le premier groupe après les groupes devant être retirés.

8. Procédé selon la revendication 7, **caractérisé en ce qu'**à l'intérieur d'un groupe, une ou plusieurs trames vocales sont supprimées de la reproduction, au début et/ou à la fin du groupe, par le fait que l'information de validité (Clx) du groupe est modifiée de telle sorte que l'emplacement de mémoire de la première trame vocale (adresse de départ) et/ou le nombre de trames vocales mémorisées (nombre de trames vocales) est à nouveau mémorisé en un emplacement de mémoire prévu à cet effet.

9. Procédé pour délivrer des données vocales délivrées dans des fichiers, dans une machine à dicter numérique, selon lequel la mémoire est divisée en groupes pour des données vocales et à chaque groupe est associée une référence dans une table d'affectation de fichiers (FAT), désignant le groupe immédiatement suivant), et au dernier groupe de fichiers est associé un signal de fin de fichier (-), et
selon lequel les données vocales mémorisées dans un fichier sont lues à partir de la mémoire dans la succession indiquée dans la table d'affectation de fichiers (FAT),
**caractérisé en ce**
**qu'**une information de validité (Clx) est mémorisée dans un groupe, est évaluée par une unité de commande, et les trames vocales caractérisées ainsi comme valables et mémorisées dans le groupe sont lues dans la mémoire, sont décodées et sont délivrées.

10. Procédé selon la revendication 9, **caractérisé en ce que** l'unité de commande évalue l'information de validité mémorisée (Clx), constituée par l'adresse de départ de la première trame vocale (adresse de départ) et le nombre de trames vocales mémorisées (nombre de trames vocales) suffisamment fréquemment pour que les unités de commande identifie que pour l'adresse de départ de la première trame vocale et/ou pour le nombre de trames vocales mémorisées, une valeur impossible est présente et qu'alors les valeurs déterminées juste auparavant sont utilisées, ce qui a pour effet qu'en permanence l'information de validité (Clk) mémorisée en dernier lieu est utilisée.

11. Procédé selon la revendication 9 ou 10,
**caractérisé en ce que** les en têtes de trames vocales contiennent des identificateurs qui indiquent si l'information vocale ou une information de pause de conversation est contenue dans les trames.

12. Procédé selon Tune des revendications 9 à 11,
**caractérisé en ce que** les caractéristiques d'étagement de qualité des signaux vocaux sont contenues dans les en-têtes de trames vocales.
